# EUROPEAN PATENT SPECIFICATION

(11) **EP 3 258 601 B1**
(45) Date of publication and mention of the grant of the patent: **03.03.2021**
(21) Application number: 17175826.1
(22) Date of filing: 13.06.2017
(51) Int. Cl.: H03K 17/18, B60L 3/00, G01R 31/327, H03K 17/687, H02H 7/18, H02J 7/00

(54) **POWER SUPPLY SHUT-OFF DEVICE**
STROMVERSORGUNGS-ABSCHALTVORRICHTUNG
DISPOSITIF D'ARRÊT D'ALIMENTATION ÉLECTRIQUE

(30) Priority: 14.06.2016 JP 2016117745
(43) Date of publication of application: 20.12.2017
(73) Proprietor: AISIN SEIKI KABUSHIKI KAISHA, Kariya-shi, Aichi-ken, 448-8650 (JP)
(72) Inventor: MIYAKE, Motofumi, KARIYA-SHI, AICHI-KEN, 448-8650 (JP)
(74) Representative: Cabinet Beau de Loménie

(56) References cited:
- FR-A1- 2 991 461
- US-A- 5 583 384
- US-A1- 2007 284 664
- US-A1- 2009 160 405
- US-A1- 2012 217 937

## Description

### TECHNICAL FIELD

Embodiments disclosed herein relate to a power supply shut-off device that controls energization of a power.

### BACKGROUND DISCUSSION

For example, in electric equipment of related art, relays have been used in view of safety and operability. The relays include a relay configured using a semiconductor switch, as disclosed in, for example, Journal of Technical Disclosure No. 2012-504284 published by the Japan Institute for Promoting Invention and Innovation (Reference 1) Another example of relay using semiconductor switches is disclosed in document US 5.583.384 wherein two field effect transistors have their sources connected together and wherein each field effect transistor has a parallel parasitic diode.

In the power supply shut-off device disclosed in Reference 1, a pair of field effect transistors are provided in a power supply line in a state where drain terminals of the pair of field effect transistors are connected to each other, and it is diagnosed whether the pair of field effect transistors are failed, based on a voltage value obtained by dividing voltages of the drain terminals by two resistors (hereinafter, referred to as a "divided voltage value").

In the power supply shut-off device disclosed in Reference 1, the failure diagnosis of the field effect transistors is performed based on a divided voltage value obtained when both the pair of field effect transistors are in the OFF state, a divided voltage value obtained when only one of the pair of field effect transistors is in the ON state, and a divided voltage value obtained when both the pair of field effect transistors are in the ON state. Hence, the failure diagnosis according to the technology disclosed in Reference 1 may not be actually performed while supplying power to the downstream side via the power supply shut-off device, and needs to be performed prior to using the power shut-off device. Further, since the failure diagnosis is performed by appropriately switching the operations of the pair of field effect transistors, the failure diagnosis takes time.

Thus, a need exists for a power supply shut-off device capable of performing failure diagnosis during actual use thereof.

### SUMMARY

This object is achieved by a power supply shut-off device according to appended claim 1.

A power supply shut-off device according to an aspect of this disclosure includes: a pair of field effect transistors that are connected to each other at source terminals thereof, and have a P-type channel polarity; an input terminal that is connected to a drain terminal of one of the pair of field effect transistors and supplied with a power from a battery; an output terminal that is connected to a drain terminal of the other of the pair of field effect transistors and supplies the power to a load; a pair of temperature detection elements that are installed adjacent to the drain terminals of the pair of field effect transistors, respectively; and a diagnosis unit that performs failure diagnosis of the pair of field effect transistors based on detection results by the pair of temperature detection elements.

With this configuration, since the source terminals of the pair of field effect transistors are connected to each other, parasitic diodes formed within the field effect transistors, respectively, are arranged such that the rectifying current directions of the parasitic diodes are different from each other. Accordingly, in a case where the field effect transistors are failed in an open mode, when the direction in which current flows at that time follows the reverse direction of the parasitic diodes, no voltage is generated at the anode sides of the parasitic diodes, and thus, it may be determined that the field effect transistor of which the drain terminal is connected to the output terminal is failed. Meanwhile, when the direction in which current flows at the time when the field electric transistors are failed in the open mode follows the forward direction of the parasitic diodes, the temperature of the field effect transistors increases since the parasitic diodes generate heat due to the forward voltage of the parasitic diodes and the flowing current, and thus, it may be determined that the field effect transistor of which the drain terminal is connected to the input terminal is failed, based on detection results by the temperature detection elements. With this characteristic configuration, the failure diagnosis may be performed while actually using the power supply shut-off device.

The pair of temperature detection elements are connected to the drain terminals of the pair of field effect transistors, respectively.

With this configuration, the heat of the field effect transistors may be directly transferred to the temperature detection elements via the drain terminals. Accordingly, the temperature of the field effect transistors which is relatively closer to the junction temperature of the PN junction may be detected.

It is preferable that the power supply shut-off device further includes a board on which the pair of field effect transistors are mounted, and on the board, the width of a pattern to which the source terminals are connected is formed narrower than the width of a pattern to which the drain terminals are connected.

With this configuration, heat radiation from the patterns connected to the source terminals may be reduced, and the mutual heat transfer between the pair of field effect transistors may be suppressed.

It is preferable that, on the board, the patterns to which the terminals of one of the field effect transistors are connected and the patterns to which the terminals of the other of the field effect transistors are connected are arranged symmetrically with each other.

With this configuration, by using the pair of field effect transistors of which the terminals are identically arranged, the patterns to which the terminals of one of the field effect transistors are connected and the patterns to which the terminals of the other of the field effect transistors are connected may be arranged to be identical to each other. Thus, the influence of the difference in patterns with respect to the temperature environments of the pair of field effect transistors may be reduced.

It is preferable that the field effect transistors are disposed adjacent to each other.

For example, in a field effect transistor of which the drain terminal is installed on one surface of a chip, and the source terminal and the gate terminal are installed on the other surface of the chip, the heat of the field effect transistor is often radiated from the drain terminal. Thus, by adopting the above-described configuration, the heat generation of the field effect transistors may be appropriately detected.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a circuit diagram illustrating a configuration of a power supply shut-off device; and
Fig. 2 is a view illustrating an exemplary pattern formed on a board.

### DETAILED DESCRIPTION

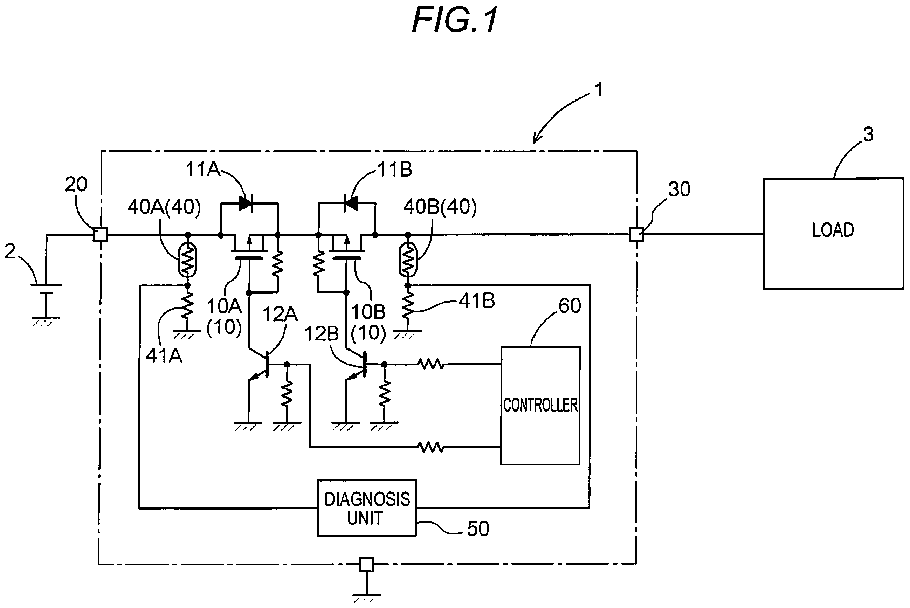

A power supply shut-off device disclosed here is configured such that failure diagnosis may be performed even during use thereof. Hereinafter, a power supply shut-off device 1 of an exemplary embodiment will be described. Fig. 1 illustrates a circuit diagram of the power supply shut-off device 1. The power supply shut-off device 1 includes a pair of field effect transistors 10 (hereinafter, referred to as "FETs"), an input terminal 20, an output terminal 30, a pair of temperature detection elements 40, a diagnosis unit 50, and a controller 60. Especially, in order to perform processes for failure diagnosis of the FETs 10, the diagnosis unit 50 is constructed in hardware, software, or both the hardware and the software using a CPU as a core member.

The pair of FETs 10 include an FET 10A and an FET 10B, and source terminals of the FET 10A and the FET 10B are connected to each other. Accordingly, the pair of FETs 10 are connected in series. Further, the pair of FETs 10 are configured using those having the same channel polarity. The same channel polarity indicates that when the FET 10A is configured using a P-type FET, the FET 10B is also configured using a P-type FET, and when the FET 10A is configured using an N-type FET, the FET 10B is also configured using an N-type FET. In this exemplary embodiment, as illustrated in Fig. 1, the pair of FETs 10 are configured using P-type FETs.

Of the pair of FETs 10, the drain terminal of the FET 10A is connected to the input terminal 20. Power is supplied to the input terminal 20 from a battery 2. The power from the battery 2 is a power to be controlled by the power supply shut-off device 1. The battery 2 may be, for example, a battery mounted on a vehicle.

Of the pair of FETs 10, the drain terminal of the FET 10B is connected to the output terminal 30. A load 3 to which the power from the battery 2 is supplied is connected to the output terminal 30. In this exemplary embodiment, the load 3 is, for example, a motor or an inductive load such as a solenoid valve.

Here, as described above, the P-type FETs are used for the pair of FETs 10. Accordingly, parasitic diodes 11A and 11B (hereinafter, referred to as "diodes 11A and 11B") are formed in a state where the anodes of the diodes 11A and 11B are connected to the drain terminals of the FETs 10A and 10B, respectively, and the cathodes of the diodes 11A and 11B are connected to the source terminals of the FETs 10A and 10B, respectively.

The collector terminals of transistors 12A and 12B (npn-type transistors in this exemplary embodiment) of which emitter terminals are grounded are connected to the gate terminals of the pair of FETs 10. The transistors 12A and 12B are configured such that current may be supplied to the base terminals thereof from the controller 60. Accordingly, when current is supplied to the base terminals of the transistors 12A and 12B from the controller 60, each of the pair of FETs 10 becomes an ON state.

The pair of temperature detection elements 40 include a temperature detection element 40A and a temperature detection element 40B. One terminal of the temperature detection element 40A is connected to the drain terminal of the FET 10A, and the other terminal of the temperature detection element 40A is connected to one terminal of a resistor 41A of which the other terminal is grounded and which has a predetermined resistance value. One terminal of the temperature detection element 40B is connected to the drain terminal of the FET 10B, and the other terminal of the temperature detection element 40B is connected to one terminal of a resistor 41B of which the other terminal is grounded and which has a predetermined resistance value. In this exemplary embodiment, the pair of temperature detection elements 40 are configured using thermistors each having a characteristic that the resistance value increases with a temperature rise. Thus, when an environmental temperature increases, a voltage value divided by the temperature detection element 40A and the resistor 41A and a voltage value divided by the temperature detection element 40B and the resistor 41B decrease. When the environmental temperature decreases, the voltage values increase.

The diagnosis unit 50 performs failure diagnosis of the pair of FETs 10 based on detection results by the pair of temperature detection elements 40. Specifically, when current is supplied to the base terminals of the transistors 12A and 12B such that the pair of FETs 10 become the ON state, the controller 60 may appropriately diagnose whether the pair of FETs 10 are failed, based on a result of comparison of the voltage value divided by the temperature detection element 40A and the resistor 41A and the voltage value divided by the temperature detection element 40B and the resistor 41B, with a predetermined value obtained by dividing the voltage from the battery 2 by the resistance values of the respective elements.

When the FET 10A is failed, the current from the battery 2 flows to the side of the FET 10B via the diode 11A. In this case, the diode 11A generates heat due to the forward voltage of the diode 11A and the current flowing through the diode 11A. Due to the heat, the resistance value of the temperature detection element 40A increases, and hence, the voltage value divided by the temperature detection element 40A and the resistor 41A becomes smaller than the predetermined value. Thus, in this case, the diagnosis unit 50 may diagnose whether the FET 10A is failed, based on the detection result by the temperature detection element 40A.

Meanwhile, when the FET 10B is failed, the current from the battery 2 does not flow to the side of the drain terminal of the FET 10B. Accordingly, the voltage value divided by the temperature detection element 40B and the resistor 41B becomes smaller than the predetermined value. Thus, in this case, the diagnosis unit 50 may diagnose whether the FET 10 B is failed, based on the detection result by the temperature detection element 40B.

In addition, a voltage may be applied from the side of the load 3 to the drain terminal of the FET 10B via the output terminal 30. In this case, current caused by the corresponding voltage flows to the ground via the diode 11B and the transistor 12B, and the diode 11B generates heat by the current and the forward voltage of the diode 11B. Due to the heat, the resistance value of the temperature detection element 40B increases, and hence, the voltage value divided by the temperature detection element 40B and the resistor 41B becomes smaller than the predetermined value. Thus, in this case, the diagnosis section 50 may diagnose whether the FET 10A is failed, based on the detection result by the temperature detection element 40A.

As described above, the power supply shut-off device 1 disclosed here determines whether the pair of FETs 10 are failed, based on the detection results by the pair of temperature detection elements 40. Especially, it is key that the resistance values of the temperature detection elements 40 change with the heat generation of the diodes 11A and 11B. Thus, the power supply shut-off device 1 may be configured as described below.

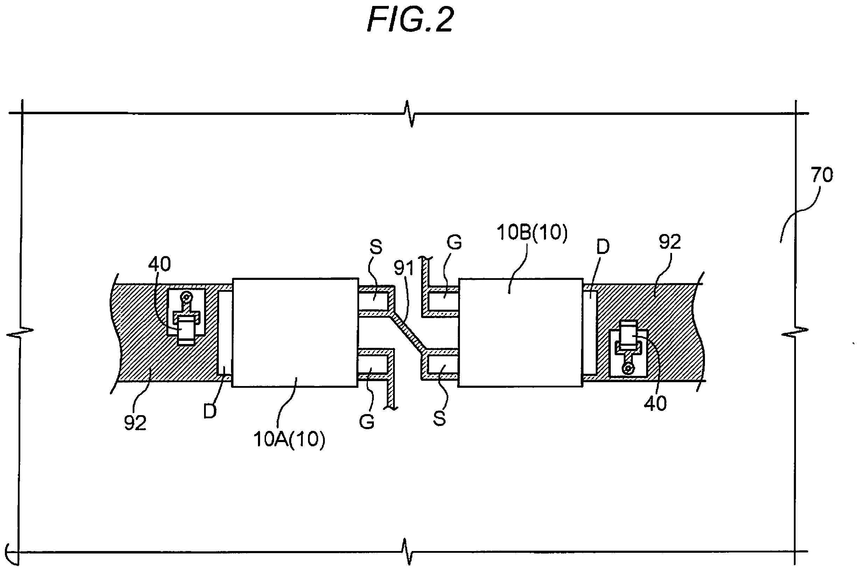

The above-described respective components, including the pair of FETs 10, are mounted on a board 70 as illustrated in Fig. 2. Here, Fig. 2 is a plan view of a portion of the board 70 on which the pair of FETs 10 are mounted. As the board 70, for example, a printed board may be used. In Fig. 2, in order to facilitate understanding, in each of the FETs 10A and 10B, the drain terminal is denoted by symbol D, the source terminal is denoted by symbol S, and the gate terminal is denoted by symbol G. Further, in Fig. 2, the hatched portion is a wiring pattern.

As illustrated in Fig. 2, the pair of temperature detection elements 40 are installed adjacent to the drain terminals D of the pair of FETs 10, respectively. Each of the FETs 10 is configured by dicing a chip formed on a semiconductor wafer and sealing the chip with a resin. The drain terminals D are installed on the back surfaces of the chips, and the source terminals S and the gate terminals G are installed on the front surface of the chip. Accordingly, since the heat of the FETs 10 is often radiated from the drain terminals D, the temperature detection elements 40 are required to be installed adjacent to the drain terminals D so as to check the heat generation of the FETs 10.

In addition, on the board 70, the width of a pattern 91 to which the source terminals S are connected is formed narrower than the width of a pattern 92 to which the drain terminals D are connected. Accordingly, heat radiation from the pattern 91 connected to the source terminals S may be reduced, and mutual heat transfer between the pair of FETs 10 may be suppressed.

In addition, the FETs 10A and 10B are arranged adjacent to each other. Accordingly, the respective temperature environments of the pair of FETs 10 may be equalized.

In addition, in this exemplary embodiment, on the board 70, the patterns to which the terminals of the FET 10A are connected and the patterns to which the terminals of the FET 10B are connected are arranged symmetrically with each other. As illustrated in Fig. 2, the arrangements of the terminals of the FETs 10 are the same in the FETs 10A and 10B. Accordingly, it is required that, on the board 70, the patterns to which the terminals of the FET 10A are connected and the patterns to which the terminals of the FET 10B are connected are arranged to be point-symmetrical with each other. Therefore, the respective temperature environments of the pair of FETs 10 may be equalized.

### [Other Exemplary Embodiments]

In the above-described exemplary embodiment, the example where the pair of FETs 10 are configured using P-type FETs has been described. However, the pair of FETs 10 may be configured using N-type FETs.

In the above-described exemplary embodiment, the example where the pair of temperature detection elements 40 are configured using thermistors has been described. However, the temperature detection elements may be configured using temperature detection elements other than thermistors.

In the above-described exemplary embodiment, it has been described that the pair of temperature detection elements 40 are connected to the drain terminals of the pair of FETs 10, respectively. However, the temperature detection elements 40 may be configured such that a resistor having a predetermined resistance value is installed between one terminal of each of the pair of temperature detection elements 40 and the drain terminal of each of the pair of FETs 10, and the other terminal of each of the pair of temperature detection elements 40 is grounded. In this case, as the pair of temperature detection elements 40, temperature detection elements each having a characteristic that the resistance value decreases with the temperature rise may be used. In this configuration as well, the voltage value divided by the temperature detection element 40A and the resistor 41A or the voltage value divided by the temperature detection element 40B and the resistor 41B may be made smaller than the predetermined value, according to the heat generation of the diode 11A or 11B. Therefore, in this case as well, it may be diagnosed whether the FETs 10A and 10B are failed, based on the detection results by the temperature detection elements 40A and 40B.

In the above-described exemplary embodiment, it has been described that, on the board 70, the width of the pattern to which the source terminals are connected is formed narrower than the width of the pattern to which the drain terminals are connected. However, the width of the pattern to which the source terminals are connected and the width of the pattern to which the drain terminals are connected may be configured to be the same. Alternatively, the width of the pattern to which the source terminals are connected may be formed wider than the width of the pattern to which the drain terminals are connected.

In the above-described exemplary embodiment, it has been described that, on the board 70, the patterns to which the terminals of the FET 10A are connected and the patterns to which the terminals of the FET 10B are connected are arranged symmetrically with each other. However, on the board 70, the patterns to which the terminals of the FET 10A are connected and the patterns to which the terminals of the FET 10B are connected may be asymmetrically arranged.

In the above-described exemplary embodiment, it has been described that the FETs 10A and 10B are arranged adjacent to each other. However, the FETs 10A and 10B may be arranged to be spaced apart from each other.

The embodiments disclosed here may be used for a power supply shut-off device that controls energization of a power.

The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive.

## Claims

1. A power supply shut-off device (1) comprising:
a pair of field effect transistors (10A, 10B) that are connected to each other at source terminals (S) thereof, and have a P-type channel polarity;
an input terminal (20) that is connected to a drain terminal (D) of one of the pair of field effect transistors, and supplied with a power from a battery (2);
an output terminal (30) that is connected to a drain terminal (D) of the other of the pair of field effect transistors, and supplies the power to a load,
a pair of temperature detection elements (40) that are installed adjacent to the drain terminals of the pair of field effect transistors, respectively,
wherein the power supply shut-off device (1) further comprises:
a pair of parasitic diodes (11A, 11B) formed within the pair of field effect transistor and having anodes connected to the drain (D) terminals of the pair of field effect transistors (10A, 10B), respectively, and cathodes connected to the source (S) terminals of the pair of field effect transistors (10A, 10B), respectively, and
a diagnosis unit (50) that performs failure diagnosis of the pair of field effect transistors based on a detection result by the pair of temperature detection elements, the failure diagnosis being performed when the pair of field effect transistors become the ON state, and the pair of temperature detection elements (40) being connected to the drain terminals(D) of the pair of field effect transistors (10A, 10B), respectively.

2. The power supply shut-off device according to claim 1, further comprising:
a board (70) on which the pair of field effect transistors are mounted, wherein, on the board, a width of a pattern (91) to which the source terminals are connected is formed narrower than a width of a pattern (92) to which the drain terminals are connected.

3. The power supply shut-off device according to claim 2, wherein, on the board, patterns to which the terminals of one of the field effect transistors are connected and patterns to which the terminals of the other of the field effect transistors are connected are arranged symmetrically with each other.

4. The power supply shut-off device according to any one of claims 1 to 3, wherein the field effect transistors are disposed adjacent to each other.

## Patentansprüche

1. Stromversorgungs-Abschaltvorrichtung (1), umfassend:
ein Paar von Feldeffekttransistoren (10A, 10B), die an ihren Source-Anschlüssen (S) miteinander verbunden sind und eine P-Kanal-Polarität aufweisen,
einen Eingangsanschluss (20), der mit einem Drain-Anschluss (D) von einem von dem Paar von Feldeffekttransistoren verbunden ist und mit einem Strom von einer Batterie (2) versorgt wird,
einen Ausgangsanschluss (30), der mit einem Drain-Anschluss (D) des anderen von dem Paar von Feldeffekttransistoren verbunden ist und den Strom einer Last zuführt,
ein Paar von Temperaturdetektierelementen (40), die den Drain-Anschlüssen des Paares von Feldeffekttransistoren jeweils benachbart angebracht sind,
wobei die Stromversorgungs-Abschaltvorrichtung (1) ferner umfasst:
ein Paar von parasitären Dioden (11A, 11B), die innerhalb des Paares von Feldeffekttransistoren ausgebildet sind und Anoden, die jeweils mit den Drain-Anschlüssen (D) des Paares von Feldeffekttransistoren (10A, 10B) verbunden sind, und Kathoden, die jeweils mit den Source-Anschlüssen (S) des Paares von Feldeffekttransistoren (10A, 10B) verbunden sind, aufweisen, und
eine Diagnoseeinheit (50), die basierend auf einem Detektierergebnis durch das Paar von Temperaturdetektierelementen Fehlerdiagnose des Paares von Feldeffekttransistoren durchführt, wobei die Fehlerdiagnose durchgeführt wird, wenn das Paar von Feldeffekttransistoren den EIN-Zustand annehmen, und wobei das Paar von Temperaturdetektierelementen (40) jeweils mit den Drain-Anschlüssen (D) des Paares von Feldeffekttransistoren (10A, 10B) verbunden ist.

2. Stromversorgungs-Abschaltvorrichtung nach Anspruch 1, ferner umfassend:
eine Platte (70), an der das Paar von Feldeffekttransistoren angebracht ist,
wobei auf der Platte eine Breite einer Struktur (91), mit der die Source-Anschlüsse verbunden sind, schmäler ausgebildet ist als eine Breite einer Struktur (92), mit der die Drain-Anschlüsse verbunden sind.

3. Stromversorgungs-Abschaltvorrichtung nach Anspruch 2, wobei auf der Platte Strukturen, mit denen die Anschlüsse von einem von den Feldeffekttransistoren verbunden sind, und Strukturen, mit denen die Anschlüsse des anderen der Feldeffekttransistoren verbunden sind, zueinander symmetrisch angeordnet sind.

4. Stromversorgungs-Abschaltvorrichtung nach einem beliebigen der Ansprüche 1 bis 3, wobei die Feldeffekttransistoren einander benachbart angeordnet sind.

## Revendications

1. Dispositif d'arrêt d'alimentation électrique (1) comprenant :
une paire de transistors à effet de champ (10A, 10B) qui sont connectés l'un à l'autre par leur borne de source (S), et qui ont une polarité de canal de type P :
une borne d'entrée (20) qui est connectée à une borne de drain (D) de l'un de la paire de transistors à effet de champ, et qui est alimentée en puissance par une batterie (2) ;
une borne de sortie (30) qui est connectée à une borne de drain (D) de l'autre de la paire de transistors des transistors à effet de champ, et qui fournit de la puissance à une charge,
une paire d'éléments de détection de température (40) qui sont installés adjacents aux bornes de drain de la paire de transistors à effet de champ, respectivement,
dans lequel le dispositif d'arrêt d'alimentation électrique (1) comprend en outre :
une paire de diodes parasites (11A, 11B) formées à l'intérieur de la paire de transistors à effet de champ et ayant des anodes connectées aux bornes de drain (D) de la paire de transistors à effet de champ (10A, 10B), respectivement, et des cathodes connectées aux bornes de source (S) de la paire de transistors à effet de champ (10A, 10B), respectivement, et
une unité de diagnostic (50) qui effectue un diagnostic de défaillance de la paire de transistors à effet de champ sur la base d'un résultat de détection par la paire d'éléments de détection de température, le diagnostic de défaillance étant effectué lorsque la paire de transistors à effet de champ passe à l'état MARCHE, et la paire d'éléments de détection de température (40) étant connectés aux bornes de drain (D) de la paire de transistors à effet de champ (10A, 10B), respectivement.

2. Dispositif d'arrêt d'alimentation électrique selon la revendication 1, comprenant en outre :
une carte (70) sur laquelle la paire de transistors à effet de champ sont montés,
dans lequel, sur la carte, une largeur d'un motif (91) auquel les bornes de source sont connectées est formée plus étroite qu'une largeur d'un motif (92) auquel les bornes de drain sont connectées.

3. Dispositif d'arrêt d'alimentation électrique selon la revendication 2, dans lequel, sur la carte, les motifs auxquels les bornes de l'un des transistors à effet de champ sont connectées, et les motifs auxquels les bornes de l'autre des transistors à effet de champ sont connectées, sont agacés symétriquement les uns par rapport aux autres.

4. Dispositif d'arrêt d'alimentation électrique selon l'une quelconque des revendications 1 à 3, dans lequel les transistors à effet de champ sont disposés adjacents l'un à l'autre.
